# EUROPÄISCHE PATENTSCHRIFT

(11) **EP 3 625 862 B1**
(45) Veröffentlichungstag und Bekanntmachung des Hinweises auf die Patenterteilung: **02.03.2022**
(21) Anmeldenummer: 18739748.4
(22) Anmeldetag: 26.06.2018
(51) Int. Cl.: H02H 3/087, H02H 7/22, H03K 17/687

(54) **ELEKTRONISCHER SCHALTER MIT ÜBERSPANNUNGSBEGRENZER**
ELECTRONIC SWITCH WITH SURGE ARRESTER
CONNECTEUR ÉLECTRONIQUE AYANT UN LIMITEUR CONTRE LES SURTENSIONS

(30) Priorität: 14.07.2017 EP 17181402
(43) Veröffentlichungstag der Anmeldung: 25.03.2020
(73) Patentinhaber: Siemens Aktiengesellschaft, 80333 München (DE)
(72) Erfinder: SCHIERLING, Hubert, 91052 Erlangen (DE); WEIS, Benno, 91334 Hemhofen (DE)
(86) Internationale Anmeldenummer: PCT/EP2018/067022
(87) Internationale Veröffentlichungsnummer: WO 2019/011642

(56) Entgegenhaltungen:
- DE-T2- 69 804 613
- US-A1- 2005 162 139
- US-A1- 2014 029 152
- US-A1- 2014 078 622

## Beschreibung

Die Erfindung betrifft einen elektronischen Schalter mit mindestens einem abschaltbaren Halbleiterschalter, einem Varistor und einem Kondensator, wobei der elektronische Schalter einen ersten Anschluss und einen zweiten Anschluss aufweist zwischen denen eine elektrisch leitende Verbindung mittels des mindestens einen abschaltbaren Halbleiterschalters abhängig vom Schaltzustand des abschaltbaren Halbleiterschalters herstellbar oder unterbrechbar ist. Ferner betrifft die Erfindung ein Gleichspannungssystem mit einem derartigen elektronischen Schalter, wobei das Gleichspannungssystem ein erstes und ein zweites elektrisches Potential aufweist, wobei einer der Anschlüsse des elektronischen Schalters mit dem ersten Potential des Gleichspannungssystems verbunden ist. Weiter betrifft die Erfindung ein Verfahren zur Begrenzung von Überspannungen in einem derartigen elektronischen Schalter oder in einem derartigen Gleichspannungssystem.

Um einen Gleichstrom schalten zu können, werden Gleichstromschalter benötigt. Im Gegensatz zum Schalten von Wechselstromschaltern sind diese deutlich komplexer aufgebaut, da im Gleichstrombetrieb, wie er beispielsweise in Gleichspannungsnetzen herrscht, der Strom keinen Nulldurchgang hat, an dem ein Verlöschen des Stromes auf einfache Weise realisiert werden kann. Ein Gleichspannungsnetz wird auch als DC-Netz bezeichnet.

Dabei hat es sich als vorteilhaft erwiesen, für den Aufbau eines Gleichstromschalters elektronische Schalter zu verwenden. Dazu zählen beispielsweise Halbleiterschalter wie Transistoren oder Thyristoren. Sofern es sich dabei um abschaltbare Halbleiter handelt, sind diese als Ersatz für mechanische Schalter zum Schalten eines Gleichstroms geeignet.

Kommt es zu einem Fehlerfall, so wird das schnelle Abschalten der Halbleiter schnell zu einem Problem. Das Problem besteht nun darin, dass die Zuleitung vom DC-Netz zur Fehlerstelle eine Induktivität aufweist, die proportional zur Länge der Leitung ist und typischerweise etwa 500nH/m beträgt. Bei einer Zuleitungslänge von 50m ergibt sich damit eine Induktivität von ca. 25µH. Durch den Abschaltvorgang des Halbleiterschalters stellt sich an dieser Induktivität eine hohe Überspannung ein, weil der Strom in der Induktivität nicht schlagartig zu Null werden kann und weiterfließen will, jedoch keinen Freilaufpfad besitzt. Deshalb steigt das Potenzial am Anschluss des Schalters auf hohe Werte an. Diese Spannung steht damit auch am elektronischen Schalter an und kann diesen beschädigen oder zerstören.

Mechanische Schalter lösen das Problem dadurch, dass sie wesentlich langsamer abschalten und zudem in ihrem Lichtbogen die gespeicherte Energie in Wärme umsetzen. Dabei haben mechanischen Schalter jedoch den Nachteil, dass sie durch ihr langsames Abschalten einen enormen Spannungseinbruch im DC-Netz erzeugen können, der andere, parallel angeschlossene Lasten beeinträchtigt.

Aus der US2005/162139 A1 ist ein Wechselspannungsschaltkreis bekannt, der einen Feldeffekttransistor umfasst. Dieser Schaltkreis umfasst zwei Feldeffekttransistoren, deren Gate-Anschlüsse miteinander gekoppelt sind. Darüber hinaus weist dieser Schaltkreis Dioden auf.

Aus der DE 698 04 613 T2 ist ein Verfahren zum Schutz einer als Schalter verwendeten Feldeffekttransistoreinheit gegen eine kurzfristige Überspannung bekannt. Dazu wird die Spannung der Feldeffekttransistoreinheit überwacht, insbesondere dann, wenn sich die Feldeffekttransistoreinheit sich im nichtleitenden Zustand befindet. Sobald diese Spannung einen voreingestellten Grenzwert übersteigt, wird die Feldeffekttransistoreinheit zumindest teilweise in einen leitenden Zustand geschaltet.

Aus der US 2014/078622 A1 ist ein Schaltelement bekannt, dass eingehende und ausgehende Gleichspannungsverbindungen miteinander verbindet.

Der Erfindung liegt die Aufgabe zugrunde, einen elektronischen Schalter zu verbessern.

Diese Aufgabe wird durch einen elektronischen Schalter mit den Merkmalen des Anspruchs 1 gelöst. Diese Aufgabe wird weiter durch einen elektronischen Schalter mit den Merkmalen des Anspruchs 5 gelöst. Ferner wird die Aufgabe durch einen Gleichspannungssystem mit den Merkmalen des Anspruchs 10 gelöst. Weiter wird die Aufgabe durch ein Verfahren zur Begrenzung von Überspannungen in einem derartigen elektronischen Schalter oder in einem derartigen Gleichspannungssystem gelöst, wobei induktive Energie eines mit dem elektronischen Schalter verbundenen Elementes bei einem Abschaltvorgang mindestens eines abschaltbaren Halbleiterschalters nach Überschreiten einer durch den Varistor festgelegten Grenze in den Kondensator übertragen wird.

Der Erfindung liegt die Erkenntnis zugrunde, dass sich eine Überspannung, hervorgerufen durch Induktivitäten im System durch eine Reihenschaltung eines Varistors und eines Kondensators auf einfache Weise beseitigen lässt. Dadurch kann zuverlässig eine Beschädigung oder Zerstörung des abschaltbaren Halbleiters oder der abschaltbaren Halbleiter des elektronischen Schalters vermieden werden. Dem Varistor kommt dabei die Aufgabe zu, im Falle einer erhöhten Spannung leitend zu werden und die induktive Energie, die in einem Element des Gleichspannungssystems gespeichert ist, d.h. die elektrische Energie, die beispielsweise in Induktivitäten, insbesondere parasitären Induktivitäten gespeichert ist, einem Kondensator zuzuführen. Dieser Kondensator nimmt die Energie zerstörungsfrei auf.

Will man hingegen den elektronischen Schalter lediglich mit einem Varistor ohne die Verwendung eines Kondensators vor Überspannungen schützen, so ist dieser schwierig zu dimensionieren. Bei einer maximalen Spannung des DC-Netzes von beispielsweise 850V darf er nur einen minimalen Strom aufnehmen, damit er im Fehlerfall nicht zerstört wird. Bei einer angenommenen maximalen Sperrspannung der Halbleiter von beispielsweise 1200V muss er jedoch den kompletten Fehlerstrom führen, um die Überspannung zu begrenzen. Varistoren mit derart harten Kennlinien sind nicht wirtschaftlich verfügbar.

Verwendet man anstelle des Varistors lediglich einen Kondensator, um die induktive Energie aufzunehmen, so muss dieser entsprechend groß dimensioniert werden, damit er die Energie aufnehmen kann ohne auf unzulässige hohe Werte geladen zu werden. Die Auslegungsregel für die Kapazität des Kondensators ist dabei abhängig vom Quadrat des Quotienten aus Abschaltstrom des Halbleiters und zulässiger Spannungsüberhöhung über die betriebsmäßige DC-Spannung hinaus. Hierdurch ergeben sich hohe geforderte Werte für die Kapazität C des Kondensators. Da der Fehler zudem in jeder Stromflussrichtung auftreten kann, der Kondensator jedoch bei Verwendung eines Elektrolytkondensators nur in einer Richtung Spannung aufnehmen kann, und bei Wiederzuschalten des Halbleiters der Ladestrom des Kondensators begrenzt werden muss, ist die Begrenzungsgestaltung für beide Spannungsrichtungen getrennt auszuführen, beispielsweise durch eine RCD-Beschaltung.

Erst durch die erfindungsgemäße Kombination eines Varistors mit einem Kondensator zu einer Reihenschaltung führt zu einer besonders vorteilhaften Lösung, bei der die Anforderungen an den Varistor wie auch an die Kapazität C des Kondensators derart gering sind, dass diese Schaltung einfach und kostengünstig herstellbar und realisierbar ist.

Ordnet man die Reihenschaltung aus Varistor und Kondensator so an, das sie mit ihrem ersten Ende über Dioden mit den jeweiligen Anschlüssen des elektronischen Schalters verbunden sind, einer dieser Anschlüsse mit einem ersten Potential des DC-Netzes verbunden ist und das zweite Ende der Reihenschaltung mit einem zweiten Potential des DC-Netzes verbunden ist, kann der Varistor deutlich weniger leistungsfähig ausgelegt werden. Es kann somit ein kostengünstigerer Varistor verwendet werden.

Durch diese Schaltanordnung ist es möglich, eine Überspannung bei einem Abschaltvorgang eines Stroms für beide Stromflussrichtungen erfolgreich zu begrenzen, auch wenn der Kondensator ein unipolarer Kondensator ist. Somit eignen sich insbesondere Elektrolytkondensatoren für die Verwendung in einem Überspannungsbegrenzer eines elektronischen Schalters. Dabei weist der elektronische Schalter mindestens zwei abschaltbare Halbleiterschalter auf, die in einer Reihenschaltung angeordnet sind, wobei zwei der mindestens zwei abschaltbaren Halbleiterschalter antiseriell zueinander angeordnet sind, wobei die Reihenschaltung zwischen dem ersten Anschluss und dem zweiten Anschluss des elektronischen Schalters angeordnet ist. Mit dieser Anordnung lassen sich Gleichströme unterschiedlicher Polarität mit dem elektronischen Schalter schalten. Antiseriell bedeutet in diesem Zusammenhang, dass die abschaltbaren Halbleiterschalter jeweils so angeordnet sind, dass das Schaltelement des abschaltbaren Halbleiterschalters jeweils einen Strom unterschiedlicher Polarität führen und abschalten können. Dabei weisen die einzelnen abschaltbaren Halbleitermodule oftmals bereits eine Diode auf, die parallel zum Schaltelement des Halbleiterschalters angeordnet ist. Die Diode ist dabei antiparallel zum Schaltelement des abschaltbaren Halbleiterschalters ausgeführt. D.h., dass die einen Strom führen kann, der dem Strom durch das Schaltelement entgegengesetzt ist. Solche abschaltbaren Halbleiterschalter werden auch als rückwärtsleitende Schalter bezeichnet.

Durch die Dioden, die zwischen Varistor und Kondensator und den jeweiligen Anschlüssen des elektronischen Schalters angeordnet sind, ist es möglich, mit der Reihenschaltung aus Varistor und Kondensator eine Energie aus einer Induktivität aufzunehmen, die unabhängig von der Stromflussrichtung durch den Schalter ist. Somit kann auf einfache Weise ein Schutz vor unzulässig hohen Spannungen an den abschaltbaren Halbleiterschaltern vermieden werden. Dazu ist nur ein Überspannungsbegrenzer in Form einer Reihenschaltung aus Varistor und Kondensator erforderlich.

Dabei ist die erste Diode mit ihrer Anode mit dem ersten Anschluss des elektronischen Schalters verbunden und mit ihrer Kathode mit einem ersten Ende der Reihenschaltung aus dem Varistor und den Kondensator verbunden, wobei die zweite Diode mit ihrer Anode mit dem zweiten Anschluss des elektronischen Schalters verbunden ist und mit ihrer Kathode mit der Kathode der ersten Diode verbunden ist. Mit der Anordnung der Dioden in dieser Orientierung ist es möglich, eine Überspannung auf zulässige Werte für die abschaltbaren Halbleiterschalter zu begrenzen, die unabhängig von der Stromflussrichtung eines abzuschaltenden Stroms durch den elektronischen Schalter ist. Für die Dioden können in vorteilhafter Weise die bereits vorhandenen antiparallel angeordneten Dioden des abschaltbaren Halbleiterschalters genutzt werden. Auf die Verwendung weiterer bzw. zusätzlicher Dioden kann damit verzichtet werden. Alternativ ist es auch möglich, neben den bereits vorhandenen Dioden des abschaltbaren Halbleiterschalters weitere Dioden zu verwenden, die wie beschrieben angeordnet sind. Damit können die abschaltbaren Halbleiterschalter beliebig innerhalb des elektronischen Schalters angeordnet werden.

Besonders vorteilhaft ist dieser Ausgestaltungsform, wenn der elektronische Schalter in einem ersten Potential eines DC-Netzes angeordnet ist und das zweite Ende der Reihenschaltung aus Varistor und Kondensator mit einem zweiten Potential des DC-Netzes verbunden ist. Das erste und das zweite Potential des DC-Netzes bilden in ihrer Differenz die Spannung des DC-Netzes.

Bei einer vorteilhaften Ausgestaltung der Erfindung ist parallel zu der Reihenschaltung aus erster und zweiter Diode ein Widerstand angeordnet. Für den Fall, dass das zweite Ende der Reihenschaltung aus Varistor und Kondensator mit einem zweiten Potential des DC-Netzes verbunden ist, muss im Betrieb bzw. vor Beginn des Betriebs der Kondensator auf die Spannung des DC-Netzes aufgeladen werden. Um dabei einem zu hohen Ladestrom zu vermeiden, hat es sich als vorteilhaft erwiesen, einen Widerstand zu verwenden, und diesen parallel zu der Reihenschaltung der Dioden anzuordnen. Fügt man zu der ersten Diode in Reihe noch einen ersten Schalter ein, so kann durch Öffnen des Schalters erreicht werden, dass ein Ladestrom für den Kondensator über den Widerstand fließt. Unzulässig hohe Ladeströme für den Kondensator im DC-Netz können damit zuverlässig vermieden werden.

Bei einer weiteren vorteilhaften Ausgestaltung der Erfindung ist in Reihe zu dem Widerstand ein zweiter Schalter angeordnet. Mit diesem Schalter ist es auf einfache Weise möglich, die Vorladung des Kondensators über den Widerstand zu steuern oder zu regeln.

Bei einer weiteren vorteilhaften Ausgestaltung der Erfindung ist zwischen dem ersten Anschluss des elektronischen Schalters und einem der abschaltbaren Halbleiterschalter ein dritter Schalter, insbesondere ein mehrpoliger Schalter, angeordnet. Dieser Schalter dient dazu, den elektronischen Schalter galvanisch vom DC-Netz zu trennen. Darüber hinaus ist es möglich, mit diesem dritten Schalter auf den ersten Schalter zu verzichten und trotzdem eine Vorladung des Kondensators über den Widerstand zu ermöglich. Der Verzicht auf den ersten Schalter wirkt sich besonders positiv auf die Kosten des Überspannungsbegrenzers aus, da der erste Schalter für den Fehlerfall auf einen hohen Strom ausgelegt sein muss. Durch diese Ausgestaltung kann auf den ersten Schalter verzichtet werden, was zu deutlichen günstigeren Kosten im Schalteraufbau führt.

Bei einer weiteren vorteilhaften Ausgestaltung der Erfindung weist der elektronische Schalter mindestens vier Dioden auf, wobei die mindestens vier Dioden eine Brückengleichrichterschaltung bilden, wobei die Reihenschaltung aus dem Varistor und dem Kondensator in dem gleichgerichteten Pfad der Brückengleichrichterschaltung angeordnet ist und die Eingänge der Brückengleichrichterschaltung jeweils mit einem der Anschlüsse des elektronischen Schalters verbunden sind. Mit dieser Anordnung ist es möglich, einen Überspannungsbegrenzer zu realisieren, der keinen Kontakt mit einem zweiten Potential des DC-Netzes erfordert. Damit können sämtliche Maßnahmen über die Vorladung des Kondensators entfallen. Die Begrenzungsschaltung als Reihenschaltung von Varistor und Kondensator kann auf einfache Weise in dem elektronischen Schalter realisiert werden, ohne dass sich die Anzahl der Anschlüsse des elektronischen Schalters erhöht. Mit anderen Worten, kommt der elektronische Schalter mit dieser Art von Überspannungsbegrenzer weiterhin mit genau zwei Anschlüssen aus. Durch die Gleichrichterschaltung ist es möglich, diesen Überspannungsbegrenzer für einen elektronischen Schalter zu verwenden, der einen Strom in beide Stromflussrichtungen abschalten kann.

Durch die Gleichrichtschaltung wird darüber hinaus sichergestellt, dass die Verwendung eines unipolaren Kondensators zur Spannungsbegrenzung unabhängig von der Stromflussrichtung durch den Schalter möglich ist. Insbesondere der Einsatz von Elektrolytkondensatoren, die Kostengünstig verfügbar sind, ist für diese Ausgestaltung besonders vorteilhaft.

Bei einer weiteren vorteilhaften Ausgestaltung der Erfindung weist der elektronische Schalter einen dritten Anschluss auf, wobei ein zweites Ende der Reihenschaltung aus Varistor und Kondensator mit dem dritten Anschluss verbunden ist. Der erste und der zweite Anschluss dienen dazu eine Verbindung in einem Gleichspannungssystem unterbrechen zu können. Das zweite Ende der Reihenschaltung ist damit das nicht mit der ersten und zweiten Diode verbundene Ende der Reihenschaltung. Somit ist der erste Anschluss mit einem ersten Potential des Gleichspannungssystems verbunden. Der dritte Anschluss ist dazu vorgesehen und/oder ausgelegt mit einem zweiten Potential des Gleichspannungssystems verbunden zu werden. Um Energie über ein Gleichspannungssystem zu übertragen müssen mindestens zwei unterschiedliche Potentiale vorhanden sein. Diese können in vorteilhafter Weise zum Anschluss an den ersten Anschluss und dem dritten Anschluss genutzt werden. Ebenso ist es möglich, das Erdpotential als zweites Potential zu verwenden.

Im Folgenden wird die Erfindung anhand der in den Figuren dargestellten Ausführungsbeispiele näher beschrieben und erläutert. Es zeigen:

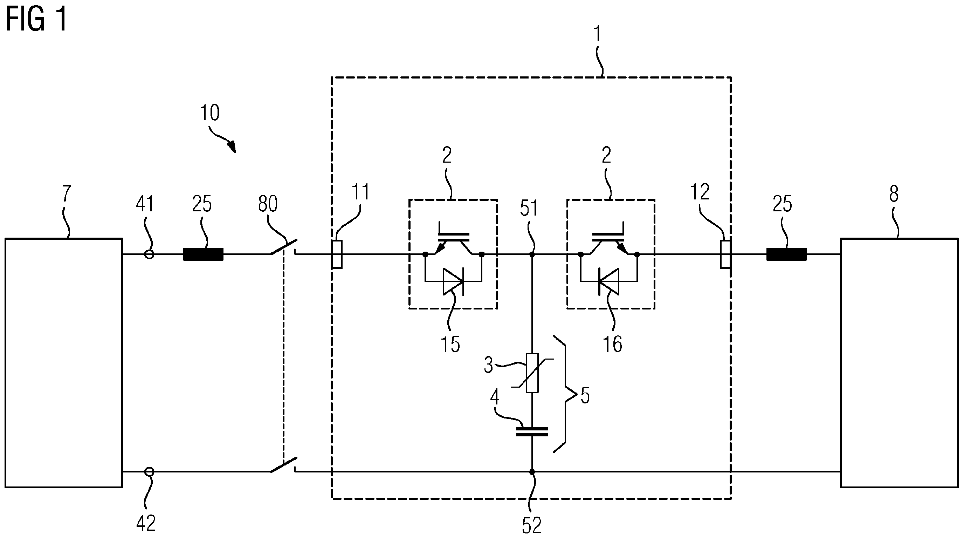

- FIG 1 bis FIG 5: Ausführungsbeispiele für einen elektronischen Schalter mit Überspannungsbegrenzer.

Die FIG 1 zeigt ein Gleichspannungssystem 10 mit einer Last 8, die von einem DC-Netz 7 gespeist wird. Zwischen dem ersten Potential 41 und dem zweiten Potential 42 liegt die Gleichspannung des DC-Netzes 7 an. Zwischen DC-Netz 7 und Last 8 ist ein elektronischer Schalter 1 angeordnet. Neben diesem elektronischen Schalter 1 befindet sich noch ein Schütz oder Trenner 80 mit dem die Last 8 vom DC-Netz 7 galvanisch getrennt werden kann. Für die Funktion des elektronischen Schalters 1 ist das Schütz oder der Trenner 80 nicht zwingend erforderlich. Die in den Zuleitungen vorhandenen Induktivitäten sind durch das Element 25 dargestellt. Dabei kann es sich um parasitäre Induktivitäten von Leitungen oder auch um induktive Bauelemente, wie Drosseln, Spulen oder Transformatoren handeln. Der elektronische Schalter 1 weist zwischen seinem ersten Anschluss 11 und seinem zweiten Anschluss 12 eine Reihenschaltung von zwei abschaltbaren Halbleiterschaltern 2 auf. Diese sind antiseriell zueinander angeordnet. Das bedeutet, dass das Schaltelement der beiden abschaltbaren Halbleiterschalter 2 jeweils einen Strom mit unterschiedlicher Richtung führen und damit schalten kann. Zur Erhöhung der Sperrfähigkeit, d.h. der zu schaltenden Spannung kann die Anzahl der abschaltbaren Halbleiterschalter 2 in der Reihenschaltung 5 weiter erhöht werden.

Parallel zu dem Schaltelement ist eine Diode 15,16 antiparallel angeordnet. D.h. dass der Strom durch die Diode in die andere Richtung fließt als der Strom durch das entsprechend antiparallele Schaltelement des abschaltbaren Halbleiterschalters 2. Die antiserielle Anordnung der beiden abschaltbaren Halbleiterschalter 2 führte dazu, dass der Strom zwischen erstem Anschluss 11 und zweitem Anschluss 12 durch eine Diode des einen abschaltbaren Halbleiterschalters und durch ein Schaltelement des anderen abschaltbaren Halbleiterschalters fließt. Die Reihenschaltung der abschaltbaren Halbleiterschalter 2 ist mit dem ersten Potential 41 des DC-Netzes 7 verbunden. Der elektronische Schalter 1 weist darüber hinaus einen Varistor 3 und einen Kondensator 4 auf. Diese bilden eine Reihenschaltung 5. Diese Reihenschaltung 5 ist mit einem ersten Ende 51 mit der Reihenschaltung der zwei abschaltbaren Halbleiterschalter verbunden. Die Verbindung ist derart ausgeführt, dass über die Dioden 15, 16 ein Strom jeweils von dem ersten Anschluss 11 und/oder dem zweiten Anschluss 12 zu der Reihenschaltung 5 aus Varistor 3 und Kondensator 4 fließen kann, auch wenn die abschaltbaren Halbleiterschalter geöffnet, d.h. gesperrt, sind. Das zweite Ende 52 der Reihenschaltung 5 aus Varistor 3 und Kondensator 4 ist mit dem zweiten Potential 42 des DC-Netzes 7 verbunden.

Fließt nun ein Strom im ersten Potential 41 von dem DC-Netz 7 zur Last 8 durch den elektronischen Schalter 1 so ist die Diode 15 leitend und die Diode 16 gesperrt. Der Strom fließt durch das Schaltelement des abschaltbaren Halbleiterschalters 2, der zu der Diode 16 parallel angeordnet ist. Schaltet nun der elektronische Schalter 1 ab, indem der abschaltbare Halbleiterschalter gesperrt wird, so wird der Strom durch die Induktivität des Elementes 25 weiter betrieben. Dieser fließt vom ersten Anschluss 11 über die Diode 15 in die Reihenschaltung 5 aus Varistor 3 und Kondensator 4. Sobald ein vom Varistor vorgegebener Spannungswert überschritten wird, wird der Varistor 3 leitend und der Kondensator 4 nimmt die Energie des Elementes 25 auf, bis der Strom zu Null wird. Eine Überspannung an den abschaltbaren Halbleiterschaltern 2 wird dadurch zuverlässig vermieden. Entsprechendes gilt auch für einen Stromfluss von der Last 8 zum DC-Netz 7. In diesem Fall kehrt sich das Verhalten der beiden abschaltbaren Halbleiterschalter 2 um.

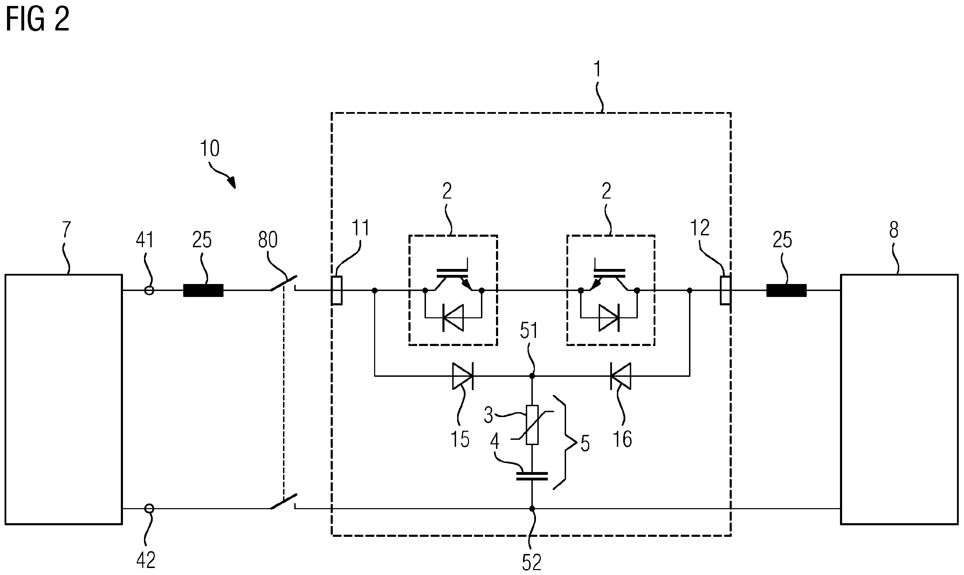

Die FIG 2 zeigt ein weiteres Ausführungsbeispiel für einen elektronischen Schalter 1 mit einem Überspannungsbegrenzer. Zur Vermeidung von Wiederholungen wird auf die Beschreibung zu FIG 1 sowie auf die dort eingeführten Bezugszeichen verwiesen. In diesem Ausführungsbeispiel werden Dioden 15, 16 verwendet, die nicht innerhalb des abschaltbaren Halbleiterschalters angeordnet sind. Diese Dioden 15, 16 dienen dem Überspannungsschutz. Sie können somit auf die Gegebenheiten, d.h. die zulässigen und zu erwartenden Strom- und Spannungswerte ausgelegt werden. Darüber hinaus können die abschaltbaren Halbleiterschalter 2 beliebig in ihrer Reihenschaltung angeordnet werden. Das erste Ende der Reihenschaltung 5 aus Varistor 3 und Kondensator 4 ist nun mit dem Verbindungspunkt der beiden Dioden 15, 16 verbunden. Die Reihenschaltung 5 aus Varistor 3 und Kondensator 4 ist nun von einem Verbindungspunkt zwischen den abschaltbaren Halbleiterschaltern 2 getrennt. Anders ausgedrückt besteht zu der Reihenschaltung 6 der beiden abschaltbaren Halbleiterschalter 2 nun keine Verbindung mehr. Auch mit diesem Ausführungsbeispiel lässt sich ein zuverlässiger Schutz der abschaltbaren Halbleiterschalter 2 gegenüber einer unzulässig hohen Spannung realisieren.

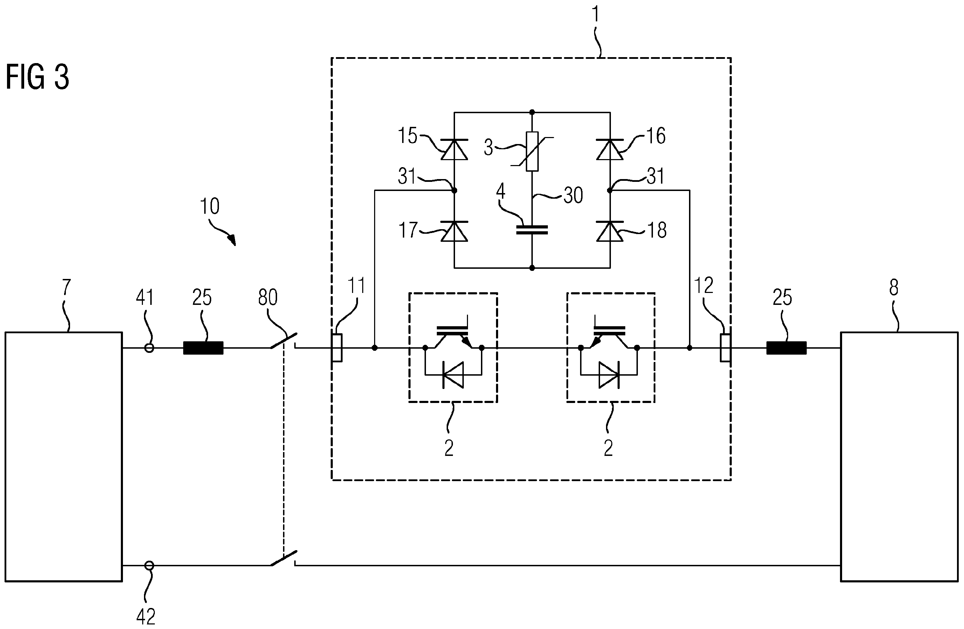

FIG 3 zeigt ein weiteres Ausführungsbeispiel für einen elektronischen Schalter 1 mit einem Spannungsbegrenzer. Zur Vermeidung von Wiederholungen wird auf die Beschreibung zu den Figuren 1 und 2 sowie auf die dort eingeführten Bezugszeichen verwiesen. Das spannungsbegrenzende Element aus Varistor 3 und Kondensator 4, die auch hier in einer Reihenschaltung 5 angeordnet sind, ist nun unabhängig vom zweiten Potential 42 des DC-Netzes 7. Die Reihenschaltung 5 aus Varistor 3 und Kondensator 4 wird über eine Brückengleichrichterschaltung mit dem ersten Anschluss 11 und dem zweiten Anschluss 12 des elektronischen Schalters 1 verbunden. Dabei befindet sich die Reihenschaltung 5 aus Varistor 3 und Kondensator 4 im gleichgerichteten Pfad 30 der Brückengleichrichterschaltung. Die Brückengleichrichterschaltung weist dabei neben der ersten Diode 15 und der zweiten Diode 16 eine dritte Diode 17 und eine vierte Diode 18 auf, die in einer Gleichrichterschaltung angeordnet sind. Die Eingänge 31 der Brückengleichrichterschaltung sind jeweils mit dem ersten Anschluss 11 sowie mit dem zweiten Anschluss 12 des elektronischen Schalters 1 verbunden. Durch die Brückengleichrichterschaltung kann auch bei Verwendung eines unipolaren Kondensators, beispielsweise eines Elektrolytkondensators, eine Spannungsbegrenzung unabhängig von der Stromflussrichtung durch den Schalter vorgenommen werden. Der Vorteil dieser Schaltung besteht darin, dass dieser auf einfache Weise in einen elektronischen Schalter 1 integriert werden kann und dieser nur einen ersten Anschluss 11 und einen zweiten Anschluss 12 aufweist. Auf einen Anschluss für ein zweites Potential 42 des DC-Netzes 7 kann verzichtet werden. Das macht den Schalter, insbesondere für Nachrüstungen in bestehende Anlagen, besonders interessant, da diese Lösung einfach und kostengünstig in bestehende Systeme integrierbar ist.

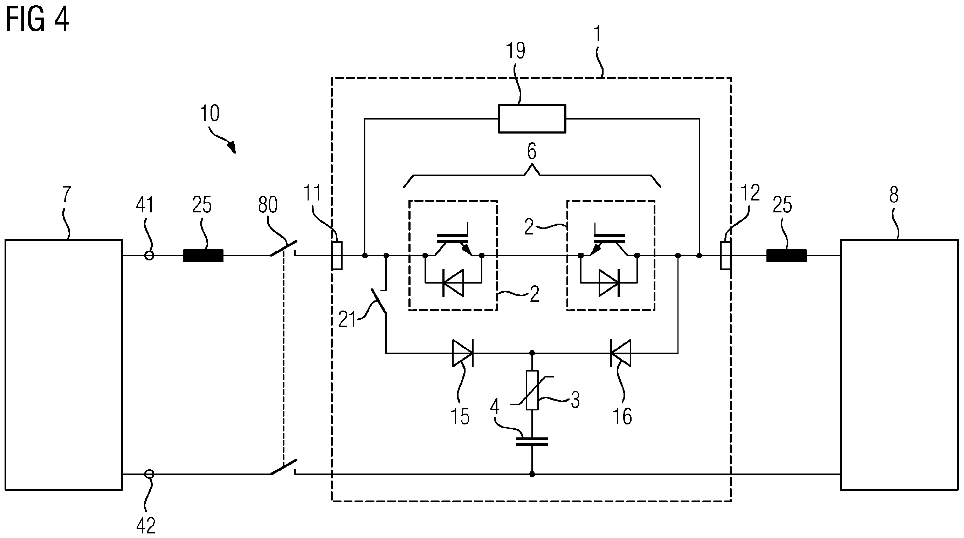

Die FIG 4 zeigt ein weiteres Ausführungsbeispiel für einen elektronischen Schalter 1. Bei dieser Ausführungsform ist ähnlich wie bei den Figuren 1 und 2 die Reihenschaltung 5 aus Varistor 3 und Kondensator 4 zwischen den ersten Potential 41 und dem zweiten Potential 42 des DC-Netzes 7 angeordnet. Je nach Auslegung des Varistors 3 kann es dazu führen, dass eine Vorladung für den Kondensator 4 beim Einschalten des elektronischen Schalters 1 stattfindet. Um die Belastung durch zu hohe Ströme im DC-Netz 7 bei der Vorladung des Kondensators 4 so gering wie möglich zu halten, kann ein Widerstand 19 als Vorderwiderstand verwendet werden. Um sicherzustellen, dass der Strom zur Ladung des Kondensators 4 über den Widerstand 19 fließt, wird in Reihe zur ersten Diode 15 ein erster Schalter 21 eingefügt. Dieser Schalter 21 bleibt für die Dauer der Vorladung geöffnet, so dass ein Strom im ersten Potential 41 vom DC-Netz über den Widerstand 19 der Diode 16 in den Kondensator 4 fließt. Zur Vermeidung von Wiederholungen wird auf die Beschreibung zu den Figuren 1 bis 3 sowie auf die dort eingeführten Bezugszeichen verwiesen.

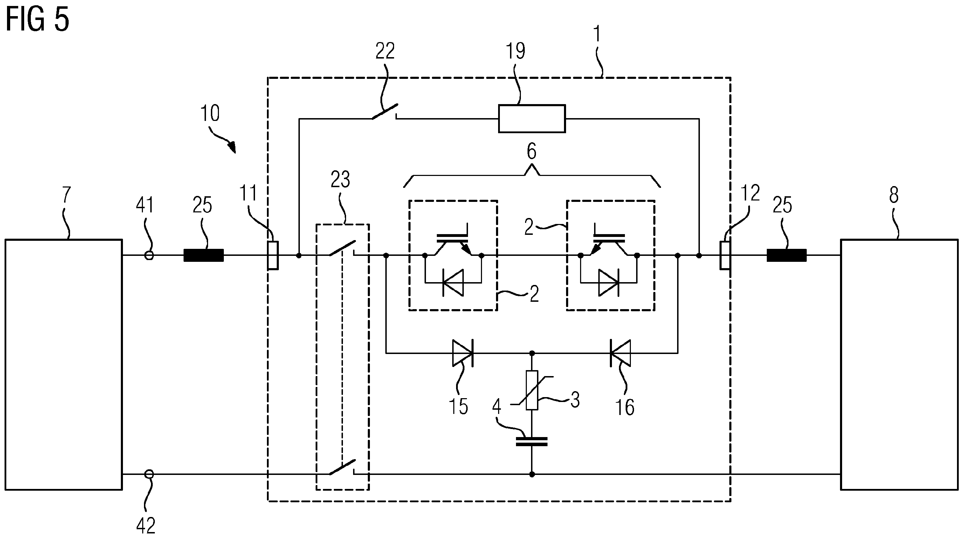

Die FIG 5 zeigt ein weiteres Ausführungsbeispiel für einen elektronischen Schalter 1 mit Überspannungsbegrenzer der ebenfalls eine Vorladung des Kondensators 4 über den Widerstand 19 ermöglicht. Zur Vermeidung von Wiederholungen wird auf die Beschreibung zu den Figuren 1 bis 4 sowie auf die dort eingeführten Bezugszeichen verwiesen. Im Unterschied zu dem Ausführungsbeispiel der FIG 4 ist in Reihe zur ersten Diode 15 kein erster Schalter mehr vorhanden. Dafür ist ein zweiter Schalter 22 in Reihe zu dem Widerstand 19 angeordnet. Dieser Schalter 22 verbindet den ersten Anschluss 11 des elektronischen Schalters 1 mit dem Widerstand 19. Ein dritter Schalter 23, vorzugsweise ausgelegt als zweipoliger Schalter, dient zur galvanischen Trennung der Last 8 vom DC-Netz 7. Dieser ist diesem Ausführungsbeispiel im elektronischen Schalter 1 angeordnet. Durch Schließen des zweiten Schalters 22 bei gleichzeitig geöffnetem dritten Schalter 23 kann erreicht werden, dass der Kondensator 4 über den Widerstand 19 und der Diode 16 vorgeladen wird. Da der Stromfluss über den Widerstand 19 erfolgt, ist diese Vorladung besonders netzfreundlich, da der Strom durch den Widerstand 19 begrenzt wird und keine unzulässig hohe Belastung darstellt. Sobald der Kondensator 4 hinreichend geladen ist, kann der dritte Schalter 23 geschlossen werden. Die Spannung am Varistor 3 entspricht der Differenz aus DC-Spannung und Spannung am Kondensator 4. Wenn der Kondensator 4 hinreichend geladen ist, ist auch die Spannung am Varistor 3 derart gering, dass dieser nicht mehr leitend ist. In diesem Fall fließt auch bei geschlossenem dritten Schalter 23 kein Strom über die erste Diode 15 zum Kondensator 4. Die Vorladung ist in diesem Fall abgeschlossen und auch der zweite Schalter 22 kann geöffnet werden.

Zusammenfassend betrifft die Erfindung einen elektronischer Schalter mit mindestens einem abschaltbaren Halbleiterschalter, einem Varistor und einem Kondensator, wobei der elektronische Schalter einen ersten Anschluss und einen zweiten Anschluss aufweist zwischen denen eine elektrisch leitende Verbindung mittels des mindestens einen abschaltbaren Halbleiterschalters je nach Schaltzustand des abschaltbaren Halbleiterschalters herstellbar oder unterbrechbar ist. Zur Verbesserung des elektronischen Schalters im Hinblick auf Schutz vor Überspannungen wird vorgeschlagen, dass eine Reihenschaltung aus dem Varistor und dem Kondensator jeweils mit einer ersten Diode mit dem ersten Anschluss und mit einer zweiten Diode mit dem zweiten Anschluss verbunden ist. Die Erfindung betrifft weiter ein Gleichspannungssystem mit einem derartigen elektronischen Schalter. Die Erfindung betrifft weiter ein Verfahren zur Begrenzung von Überspannungen in einem derartigen elektronischen Schalter oder in einem derartigen Gleichspannungssystem, wobei induktive Energie eines mit dem elektronischen Schalter verbundenen Elementes bei einem Abschaltvorgang nach Überschreiten einer durch den Varistor festgelegten Grenze in den Kondensator übertragen wird.

## Patentansprüche

1. Elektronischer Schalter (1), aufweisend
- mindestens zwei abschaltbaren Halbleiterschalter (2) und
- einen Kondensator (4),
wobei der elektronische Schalter (1) einen ersten Anschluss (11) und einen zweiten Anschluss (12) aufweist, zwischen denen eine elektrisch leitende Verbindung mittels der mindestens zwei abschaltbaren Halbleiterschalter (2) abhängig vom Schaltzustand der abschaltbaren Halbleiterschalter (2) herstellbar oder unterbrechbar ist, wobei die mindestens zwei abschaltbaren Halbleiterschalter (2) in einer Reihenschaltung (6) angeordnet sind, wobei zwei der mindestens zwei abschaltbaren Halbleiterschalter (2) antiseriell zueinander angeordnet sind, wobei die Reihenschaltung (6) der abschaltbaren Halbleiterschalter (2) zwischen dem ersten Anschluss (11) und dem zweiten Anschluss (12) des elektronischen Schalters (1) angeordnet ist, **dadurch gekennzeichnet, dass** der elektronische Schalter (1) ferner einen Varistor (3) aufweist, wobei eine Reihenschaltung (5) aus dem Varistor (3) und dem Kondensator (4) jeweils über eine erste Diode (15) mit dem ersten Anschluss (11) und über eine zweite Diode (16) mit dem zweiten Anschluss (12) verbunden ist, wobei die erste Diode (15) mit ihrer Anode mit dem ersten Anschluss (11) des elektronischen Schalters (1) verbunden ist und mit ihrer Kathode mit einem ersten Ende (51) der Reihenschaltung (5) aus dem Varistor (3) und dem Kondensator (4) verbunden ist, wobei die zweite Diode (16) mit ihrer Anode mit dem zweiten Anschluss (12) des elektronischen Schalters (1) verbunden ist und mit ihrer Kathode mit der Kathode der ersten Diode (15) verbunden ist, wobei der elektronische Schalter (1) einen dritten Anschluss aufweist, wobei ein zweites Ende (52) der Reihenschaltung (5) aus Varistor (3) und Kondensator (4) mit dem dritten Anschluss verbunden ist.

2. Elektronischer Schalter (1) nach Anspruch 1, wobei die erste Diode (15) und die zweite Diode (16) jeweils durch eine antiparallel angeordnete Diode des abschaltbaren Halbleiterschalters (2) gebildet werden.

3. Elektronischer Schalter (1) nach Anspruch 1, wobei die erste Diode (15) und zweite Diode (2) außerhalb des abschaltbaren Halbleiterschalters (2) angeordnet sind.

4. Elektronischer Schalter (1) nach Anspruch 1, wobei neben antiparallel angeordneten Dioden des abschaltbaren Halbleiterschalters (2) weitere Dioden als erste Diode (15) und zweite Diode (2) angeordnet sind.

5. Elektronischer Schalter (1), aufweisend
- mindestens zwei abschaltbaren Halbleiterschalter (2) und
- einen Kondensator (4),
wobei der elektronische Schalter (1) einen ersten Anschluss (11) und einen zweiten Anschluss (12) aufweist, zwischen denen eine elektrisch leitende Verbindung mittels der mindestens zwei abschaltbaren Halbleiterschalter (2) abhängig vom Schaltzustand der abschaltbaren Halbleiterschalter (2) herstellbar oder unterbrechbar ist, wobei die mindestens zwei abschaltbaren Halbleiterschalter (2) in einer Reihenschaltung (6) angeordnet sind, wobei zwei der mindestens zwei abschaltbaren Halbleiterschalter (2) antiseriell zueinander angeordnet sind, wobei die Reihenschaltung (6) der abschaltbaren Halbleiterschalter (2) zwischen dem ersten Anschluss (11) und dem zweiten Anschluss (12) des elektronischen Schalters (1) angeordnet ist, **dadurch gekennzeichnet, dass** der elektronische Schalter (1) ferner einen Varistor (3) aufweist, wobei eine Reihenschaltung (5) aus dem Varistor (3) und dem Kondensator (4) jeweils über eine erste Diode (15) mit dem ersten Anschluss (11) und über eine zweite Diode (16) mit dem zweiten Anschluss (12) verbunden ist, wobei die erste Diode (15) mit ihrer Anode mit dem ersten Anschluss (11) des elektronischen Schalters (1) verbunden ist und mit ihrer Kathode mit einem ersten Ende (51) der Reihenschaltung (5) aus dem Varistor (3) und dem Kondensator (4) verbunden ist, wobei die zweite Diode (16) mit ihrer Anode mit dem zweiten Anschluss (12) des elektronischen Schalters (1) verbunden ist und mit ihrer Kathode mit der Kathode der ersten Diode (15) verbunden ist, wobei der elektronische Schalter (1) mindestens vier Dioden (15,16,17,18) aufweist, wobei die mindestens vier Dioden (15,16,17,18) eine Brückengleichrichterschaltung bilden, wobei die erste Diode (15) und die zweite Diode (16) Teil der Brückengleichrichtschaltung sind, wobei die Reihenschaltung (5) aus dem Varistor (3) und dem Kondensator (4) in dem gleichgerichteten Pfad (30) der Brückengleichrichterschaltung angeordnet ist und die Eingänge (31) der Brückengleichrichterschaltung jeweils mit einem der Anschlüsse (11,12) des elektronischen Schalters (1) verbunden sind.

6. Elektronischer Schalter (1) nach einem der Ansprüche 1 bis 5, wobei parallel zu einer Reihenschaltung aus erster und zweiter Diode (15,16) ein Widerstand (19) angeordnet ist.

7. Elektronischer Schalter (1) nach Anspruch 6, wobei zwischen dem ersten Anschluss (11) des elektronischen Schalters (1) und der ersten Diode (15) ein erster Schalter (21) angeordnet ist.

8. Elektronischer Schalter (1) nach einem der Ansprüche 6 oder 7, wobei in Reihe zu dem Widerstand (19) ein zweiter Schalter (22) angeordnet ist.

9. Elektronischer Schalter (1) nach einem der Ansprüche 1 bis 8, wobei zwischen dem ersten Anschluss (11) des elektronischen Schalters (1) und einem der abschaltbaren Halbleiterschalter (2) ein dritter Schalter (23), insbesondere ein mehrpoliger Schalter, angeordnet ist.

10. Gleichspannungssystem (10) mit einem elektronischen Schalter (1) nach einem der Ansprüche 1 bis 9, wobei mittels des elektronischen Schalters (1) eine elektrische Verbindung des Gleichspannungssystems zwischen dem ersten Anschluss (11) und dem zweiten Anschluss (12) des elektronischen Schalters (1) unterbrechbar ist.

11. Gleichspannungssystem (10) nach Anspruch 10, mit einem elektronischen Schalter (1) gemäß Anspruch 5, wobei das Gleichspannungssystem (10) ein erstes (41) und ein zweites (42) elektrisches Potential aufweist, wobei der erste Anschluss (11) des elektronischen Schalters (1) mit dem ersten Potential (41) des Gleichspannungssystems (10) verbunden ist, wobei der dritte Anschluss des elektronischen Schalters (1) mit dem zweiten Potential (42) des Gleichspannungssystems (10) verbunden ist.

12. Verfahren zur Begrenzung von Überspannungen in einem elektronischen Schalter (1) nach einem der Ansprüche 1 bis 9 oder in einem Gleichspannungssystem (10) nach einem der Ansprüche 10 oder 11, wobei induktive Energie eines mit dem elektronischen Schalter (1) verbundenen Elementes (25) bei einem Abschaltvorgang mindestens eines abschaltbaren Halbleiterschalters (2) nach Überschreiten einer durch den Varistor (3) festgelegten Grenze in den Kondensator (4) übertragen wird.

13. Verfahren nach Anspruch 12, wobei vor Einschalten des elektronischen Schalters (1) der Kondensator (4) mit einem Stromfluss über den Widerstand (19) gemäß Anspruch 6 vorgeladen wird.

## Claims

1. Electronic switch (1), having
- at least two turn-off semiconductor switches (2) and
- a capacitor (4),
wherein the electronic switch (1) has a first connection (11) and a second connection (12), between which an electrically conductive connection is makeable or breakable by means of the at least two turn-off semiconductor switches (2) on the basis of the switching state of the turn-off semiconductor switches (2), wherein the at least two turn-off semiconductor switches (2) are arranged in a series connection (6), wherein two of the at least two turn-off semiconductor switches (2) are arranged in antiseries with one another, wherein the series connection (6) comprising the turn-off semiconductor switches (2) is arranged between the first connection (11) and the second connection (12) of the electronic switch (1), **characterized in that** the electronic switch (1) further has a varistor (3), wherein a series connection (5) comprising the varistor (3) and the capacitor (4) is connected via a first diode (15) to the first connection (11) and via a second diode (16) to the second connection (12) in each case, wherein the first diode (15) has its anode connected to the first connection (11) of the electronic switch (1) and has its cathode connected to a first end (51) of the series connection (5) comprising the varistor (3) and the capacitor (4), wherein the second diode (16) has its anode connected to the second connection (12) of the electronic switch (1) and has its cathode connected to the cathode of the first diode (15), wherein the electronic switch (1) has a third connection, wherein a second end (52) of the series connection (5) comprising the varistor (3) and the capacitor (4) is connected to the third connection.

2. Electronic switch (1) according to Claim 1, wherein the first diode (15) and the second diode (16) are each formed by a diode of the turn-off semiconductor switch (2) that is arranged in antiparallel.

3. Electronic switch (1) according to Claim 1, wherein the first diode (15) and the second diode (2) are arranged outside the turn-off semiconductor switch (2).

4. Electronic switch (1) according to Claim 1, wherein further diodes are arranged as the first diode (15) and the second diode (2) besides diodes of the turn-off semiconductor switch (2) that are arranged in antiparallel.

5. Electronic switch (1), having
- at least two turn-off semiconductor switches (2) and
- a capacitor (4),
wherein the electronic switch (1) has a first connection (11) and a second connection (12), between which an electrically conductive connection is makeable or breakable by means of the at least two turn-off semiconductor switches (2) on the basis of the switching state of the turn-off semiconductor switches (2), wherein the at least two turn-off semiconductor switches (2) are arranged in a series connection (6), wherein two of the at least two turn-off semiconductor switches (2) are arranged in antiseries with one another, wherein the series connection (6) comprising the turn-off semiconductor switches (2) is arranged between the first connection (11) and the second connection (12) of the electronic switch (1), **characterized in that** the electronic switch (1) further has a varistor (3), wherein a series connection (5) comprising the varistor (3) and the capacitor (4) is connected via a first diode (15) to the first connection (11) and via a second diode (16) to the second connection (12) in each case, wherein the first diode (15) has its anode connected to the first connection (11) of the electronic switch (1) and has its cathode connected to a first end (51) of the series connection (5) comprising the varistor (3) and the capacitor (4), wherein the second diode (16) has its anode connected to the second connection (12) of the electronic switch (1) and has its cathode connected to the cathode of the first diode (15), wherein the electronic switch (1) has at least four diodes (15, 16, 17, 18), wherein the at least four diodes (15, 16, 17, 18) form a bridge rectifier circuit, wherein the first diode (15) and the second diode (16) are part of the bridge rectifier circuit, wherein the series connection (5) comprising the varistor (3) and the capacitor (4) is arranged in the rectified path (30) of the bridge rectifier circuit, and the inputs (31) of the bridge rectifier circuit are each connected to one of the connections (11, 12) of the electronic switch (1).

6. Electronic switch (1) according to one of Claims 1 to 5, wherein a resistor (19) is arranged in parallel with a series connection comprising the first and second diodes (15, 16).

7. Electronic switch (1) according to Claim 6, wherein a first switch (21) is arranged between the first connection (11) of the electronic switch (1) and the first diode (15).

8. Electronic switch (1) according to either of Claims 6 and 7, wherein a second switch (22) is arranged in series with the resistor (19).

9. Electronic switch (1) according to one of Claims 1 to 8, wherein a third switch (23), in particular a multipole switch, is arranged between the first connection (11) of the electronic switch (1) and one of the turn-off semiconductor switches (2).

10. DC voltage system (10) having an electronic switch (1) according to one of Claims 1 to 9, wherein an electrical connection of the DC voltage system between the first connection (11) and the second connection (12) of the electronic switch (1) is breakable by means of the electronic switch (1).

11. DC voltage system (10) according to Claim 10, having an electronic switch (1) according to Claim 5, wherein the DC voltage system (10) has a first (41) and a second (42) electrical potential, wherein the first connection (11) of the electronic switch (1) is connected to the first potential (41) of the DC voltage system (10), wherein the third connection of the electronic switch (1) is connected to the second potential (42) of the DC voltage system (10).

12. Method for limiting overvoltages in an electronic switch (1) according to one of Claims 1 to 9 or in a DC voltage system (10) according to either of Claims 10 and 11, wherein inductive energy of an element (25) connected to the electronic switch (1) is transferred to the capacitor (4) during a turn-off process of at least one turn-off semiconductor switch (2) after a limit stipulated by the varistor (3) is exceeded.

13. Method according to Claim 12, wherein before the electronic switch (1) is turned on, the capacitor (4) is precharged with a flow of current via the resistor (19) according to Claim 6.

## Revendications

1. Interrupteur (1) électronique, comportant
- au moins deux interrupteurs (2) à semi-conducteur pouvant être ouverts et
- un condensateur (4),
dans lequel l'interrupteur (1) électronique a une première borne (11) et une deuxième borne (12), entre lesquelles une liaison conductrice de l'électricité peut être ménagée ou interrompue au moyen des deux interrupteurs (2) à semi-conducteur pouvant être ouverts en fonction de l'état de coupure des interrupteurs (2) à semi-conducteur pouvant être ouverts, dans lequel les au moins deux interrupteurs (2) à semi-conducteur pouvant être ouverts sont montés suivant un montage (6) série, dans lequel deux des au moins deux interrupteurs (2) à semi-conducteur pouvant être ouverts sont montés tête bêche l'un par rapport à l'autre, dans le montage (6) série des interrupteurs (2) à semi-conducteur pouvant être ouverts est monté entre la première borne (11) et la deuxième borne (12) de l'interrupteur (1) électronique, **caractérisé en ce que** l'interrupteur (1) électronique a en outre une varistance (3), dans lequel un montage (5) série composé de la varistance (3), et du condensateur (4) est relié respectivement par une première diode (15) à la première borne (11) et par une deuxième diode (16) à la deuxième borne (12), dans lequel la première diode (15) est reliée par son anode à la première borne (11) de l'interrupteur (1) électronique et est en reliée par sa cathode à une première extrémité (51) du montage (5) série composé de la varistance (3) et du condensateur (4), dans lequel la deuxième diode (16) est reliée par son anode à la deuxième borne (12) de l'interrupteur (1) électronique et est reliée par sa cathode à la cathode de la première diode (15), dans lequel l'interrupteur (1) électronique a une troisième borne, dans lequel une deuxième extrémité (52) du montage (5) série composé de la varistance (3) et du condensateur (4) est reliée à la troisième borne.

2. Interrupteur (1) électronique suivant la revendication 1, dans lequel la première diode (15) et la deuxième diode (16) sont formées respectivement par une diode montée tête bêche de l'interrupteur (2) à semi-conducteur pouvant être ouvert.

3. Interrupteur (1) électronique suivant la revendication 1, dans lequel la première diode (15) et la deuxième diode (2) sont disposées à l'extérieur de l'interrupteur (2) à semi-conducteur pouvant être ouvert.

4. Interrupteur (1) électronique suivant la revendication 1, dans lequel, à côté des diodes montées tête bêche de l'interrupteur (2) à semi-conducteur pouvant être ouvert, d'autres diodes sont montées comme première diodes (15) et deuxième diode (16).

5. Interrupteur (1) électronique, comportant
- au moins deux interrupteurs (2) à semi-conducteur pouvant être ouverts et
- un condensateur (4),
dans lequel l'interrupteur (1) électronique a une première borne (11) et une deuxième borne (12), entre lesquelles une liaison conductrice de l'électricité peut être ménagée ou interrompue au moyen des deux interrupteurs (2) à semi-conducteur pouvant être ouverts en fonction de l'état de coupure des interrupteurs (2) à semi-conducteur pouvant être ouverts, dans lequel les au moins deux interrupteurs (2) à semi-conducteur pouvant être ouverts sont montés suivant un montage (6) série, dans lequel deux des au moins deux interrupteurs (2) à semi-conducteur pouvant être ouverts sont montés tête bêche l'un par rapport à l'autre, dans le montage (6) série des interrupteurs (2) à semi-conducteur pouvant être ouverts est monté entre la première borne (11) et la deuxième borne (12) de l'interrupteur (1) électronique, **caractérisé en ce que** l'interrupteur (1) électronique a en outre une varistance (3), dans lequel un montage (5) série composé de la varistance (3), et du condensateur (4) est relié respectivement par une première diode (15) à la première borne (11) et par une deuxième diode (16) à la deuxième borne (12), dans lequel la première diode (15) est reliée par son anode à la première borne (11) de l'interrupteur (1) électronique et est en reliée par sa cathode à une première extrémité (51) du montage (5) série composé de la varistance (3) et du condensateur (4), dans lequel la deuxième diode (16) est reliée par son anode à la deuxième borne (12) de l'interrupteur (1) électronique et est reliée par sa cathode à la cathode de la première diode (15), dans lequel l'interrupteur (1) électronique a au moins quatre diodes (15, 16, 17, 18) dans lequel les au moins quatre diodes (15, 16, 17, 18) forment un montage redresseur en pont, dans lequel la première diode (15) et la deuxième diode (16) font partie du montage redresseur en pont, dans lequel le montage (5) série composé de la varistance (3) et du condensateur (4) est monté dans le trajet (30) unidirectionnel du montage redresseur en pont et les entrées (31) du montage redresseur en pont sont reliées chacune à l'une des bornes (11, 12) de l'interrupteur (1) électronique.

6. Interrupteur (1) électronique suivant l'une des revendications 1 à 5, dans lequel une résistance (19) est montée en parallèle au montage série composé d'une première et d'une deuxième diode (15, 16) .

7. Interrupteur (1) électronique suivant la revendication 6, dans lequel un premier interrupteur (21) est monté entre la première borne (11) de l'interrupteur (1) électronique et la première diode (15) .

8. Interrupteur (1) électronique suivant l'une des revendications 6 ou 7, dans lequel un deuxième interrupteur (22) est monté en série avec la résistance (19).

9. Interrupteur (1) électronique suivant l'une des revendications 1 à 8, dans lequel un troisième interrupteur (23), notamment un interrupteur multipolaire, est monté entre la première borne (11) de l'interrupteur (1) électronique et l'un des interrupteurs (2) à semi-conducteur pouvant être ouverts.

10. Système (10) à tension continue comprenant un interrupteur (1) électronique suivant l'une des revendications 1 à 9, dans lequel, au moyen de l'interrupteur (1) électronique, une liaison électrique du système à tension continue entre la première borne (11) et la deuxième borne (12) de l'interrupteur (1) électronique peut être interrompue.

11. Système (10) à tension continue suivant la revendication 10, comprenant un interrupteur (1) électronique suivant la revendication 5, dans lequel le système (10) à tension continue a un premier (41) et un deuxième (42) potentiel électrique, dans lequel la première borne (11) de l'interrupteur (1) électronique est reliée au premier potentiel (41) du système (10) à tension continue, dans lequel la troisième borne de l'interrupteur (1) électronique est reliée au deuxième potentiel (42) du système (10) à tension continue.

12. Procédé de limitation de surtensions dans un interrupteur (1) électronique suivant l'une des revendications 1 à 9 ou dans un système (10) à tension continue suivant l'une des revendications 10 ou 11, dans lequel on transmet au condensateur (4), après dépassement d'une limite fixée par la varistance (3), de l'énergie inductive d'un élément (25) relié à l'interrupteur (1) électronique, lors d'une opération d'ouverture d'au moins un interrupteur (2) à semi-conducteur pouvant être ouvert.

13. Procédé suivant la revendication 12, dans lequel, avant de fermer l'interrupteur (1) électronique, on précharge le condensateur (4) par un flux de courant dans la résistance (19) suivant la revendication 6.
